# EUROPÄISCHE PATENTSCHRIFT

(11) **EP 1 902 148 B1**
(45) Veröffentlichungstag und Bekanntmachung des Hinweises auf die Patenterteilung: **24.09.2008**
(21) Anmeldenummer: 06762491.6
(22) Anmeldetag: 07.07.2006
(51) Int. Cl.: C22C 5/04

(54) **DOTIERTES IRIDIUM MIT VERBESSERTEN HOCHTEMPERATUREIGENSCHAFTEN**
DOPED IRIDIUM WITH IMPROVED HIGH-TEMPERATURE PROPERTIES
IRIDIUM DOPE, A PROPRIETES A HAUTE TEMPERATURE AMELIOREES

(30) Priorität: 11.07.2005 DE 102005032591
(43) Veröffentlichungstag der Anmeldung: 26.03.2008
(73) Patentinhaber: W.C. Heraeus GmbH, 63450 Hanau (DE)
(72) Erfinder: KOCH, Michael, 63486 Bruchkoebel (DE); LUPTON, Francis, David, 63571 Gelnhausen (DE); MANHARDT, Harald, 63486 Bruchkoebel (DE); MUELLER, Tobias, 63571 Gelnhausen (DE); WEILAND, Reinhold, 63517 Rodenbach (DE); FISCHER, Bernd, 07749 Jena (DE)
(74) Vertreter: Kühn, Hans-Christian
(86) Internationale Anmeldenummer: PCT/EP2006/006684
(87) Internationale Veröffentlichungsnummer: WO 2007/006513

(56) Entgegenhaltungen:
- WO-A-20/04007782
- US-A- 3 918 965
- US-A- 4 444 728
- PATENT ABSTRACTS OF JAPAN Bd. 1998, Nr. 14, 31. Dezember 1998 (1998-12-31) -& JP 10 259435 A (FURUYA KINZOKU:KK), 29. September 1998 (1998-09-29)

## Beschreibung

Die vorliegende Erfindung betrifft die Dotierung von Iridium oder Iridium-Rhenium-Legierung mit Moiybdän und Hafnium.

WO 2004/007782 nennt als eine von vielen Verwendungsmöglichkeiten von Iridium Tiegel zur Kristallzüchtung. Es werden Wolfram und/oder Zirkonium enthaltende Iridium-Legierungen beschrieben, die zusätzlich 0,01 bis 0,5 Gew.-% an weiteren Elementen wie Molybdän und Hafnium und gegebenenfalls Ruthenium mit 0,01 bis 10 Gew.-% enthalten. In dieser Schrift ist auch erwähnt, dass die Zugabe dieser zusätzlichen Elemente für sich allein genommen nicht effektiv ist.

US 4,444,728 beschreibt Iridium-Rhenium-Tiegel mit 1 bis 15 Gew.-% Rheniumanteil.

Nach US 3,918,965 werden die mechanischen Eigenschaften von Iridium durch Dotierung mit 0,65 bis 0,93 Gew.-% Hafnium stark verbessert.

Die Aufgabe der vorliegenden Erfindung liegt darin, auf Basis der ausgezeichneten Korrosionsbeständigkeit des Iridiums gegenüber oxidischen Schmelzen die Kriech- und Zeitstandsfestigkeit zu erhöhen, das Verhalten unter mechanischer Belastung zu verbessern, sowie die Grobkornbildung bei der Rekristallisation zu reduzieren.

Diese Aufgabe wird mit den Merkmalen von Anspruch 1 gelöst.

Bevorzugte Ausführungen und Anwendungen sind in den folgenden Ansprüchen beschrieben.

Zur Erhöhung der Zeitstandfestigkeit bei 1800°C erfolgt eine Dotierung von Iridium oder Iridium-Rhenium-Llegierung mit mindestens 50 ppm Molybdän und mindestens 5 ppm Hafnium, wobei die Summe aus Molybdän und Hafnium zwischen 200 ppm und 1,2 Gew.-% beträgt, insbesondere zwischen 0,02 und 0,7 Gew.-%.

Beträgt die Summe aus Molybdän und Hafnium unter 200 ppm, verliert sich der erfindungsgemäße Effekt. Oberhalb 1,2 Gew.-% wird die Verarbeitbarkeit schwieriger. Um den erfindungsgemäßen Effekt zu erzielen, reichen bei hohem Molybdängehalt bereits 5 ppm Hafnium. Bei geringem Molybdängehalt darf die Hafniumkonzentration 0,6 Gew.-% nicht übersteigen, damit die Legierung verarbeitbar bleibt.

Damit wird eine Legierung bestehend aus Iridium und gegebenenfalls Rhenium bereitgestellt, die mit Molybdän und Hafnium dotiert ist.

Die herstellungsbedingt üblichen Verunreinigungen sind hier nicht weiter betrachtet. Dabei handelt es sich bei den Verunreinigungen insbesondere um weitere Edelmetalle oder das Tiegelmaterial, welches bei der Herstellung des Iridiums dieses wiederum verunreinigt. Bewährt haben sich Legierungen aus Komponenten von 99 Gew.-%, insbesondere 99,9 Gew.-% und besonders bevorzugt 99,99 Gew.-% Reinheit.

In bevorzugter Ausführung beträgt der Anteil des Molybdäns 0,01 bis 0,8 Gew.-%, insbesondere 0,02 bis 0,3 Gew.-% Molybdän; und der Anteil des Hafniums 0,001 bis 0,4 Gew.-%, insbesondere 0,01 bis 0,2 Gew.-% Hafnium.

Hierdurch wird die Grobkornbildung bei der Rekristallisation merklich verlangsamt und die Kriech- und Zeitstsndsfestigksit erhöht. Dieses dotierte Iridium zeigt gegenüber oxidischen Schmelzen deutlich verbessertes Verhalten unter mechanischer Belastung.

Die gleichen Komponenten bewirken bei Iridium-Rhenium-Legierungen mit mindestens 85 Gew.-% Ir, vorzugsweise mit bis zu 8 Gew.-% Rhenium, insbesondere 0,1 bis 5 Gew.-% Re, noch wirkungsvollere Ergebnisse hinsichtlich reduzierter Grobkornbildung durch Rekristallisation und Hochtemperaturfestigkeit. Zusätzlich wird die Neigung zur Lunkerbildung erheblich reduziert.

In weiter bevorzugter Ausführung liegt das Gewichtsverhältnis von Molybdän zu Hafnium zwischen 3:1 und 1:1, insbesondere zwischen 2,5:1 und 1,5:1.

Zur Herstellung erfindungsgemäßer Legierungen hat es sich bewährt, IrMo- und IrHf-Vorlegierungen im Lichtbogen zu erzeugen. Diese Vorlegierungen werden im Verhältnis zur Ziellegierung in eine Iridiumschmelze eingebracht bzw. von einer Iridiumschmelze übergossen. Zusätzlich kann Re in die Ir-Schmelze eingebracht werden.

Die Erfindung wird im folgenden anhand von Beispielen verdeutlicht.
1. Mit 0,05 Gew.-% Molybdän dotiertes Iridium wird durch Dotierung mit 0,001 Gew.-% Hafnium hinsichtlich der Zeitstandfestigkeit bei 1800°C verbessert. Diese Verbesserung tritt bei einer Dotierung mit Hf zwischen 0,01 und 0,1 Gew.-% am deutlichsten auf. Bei einer Dotierung über 0,5 Gew.-% Hf wird die Verarbeitbarkeit der Legierung schwieriger.
2. Ein mit 0,3 Gew.-% Hafnium dotiertes Iridium zeigt eine Erhöhung der Zeitstandfestigkeit bei 1800°C durch Dotierung mit 0,01 Gew.-% Molybdän. Die Zeitstandfestigkeit wird weiter deutlich verbessert durch Dotierung mit Mo in einem Bereich zwischen 0,02 und 0,3 Gew.-%. Bei einer Dotierung über 0,8 Gew.-% Mo wird die Verarbeitbarkeit der Legierung schwieriger.
3. Nimmt man in den zuvor beschriebenen Beispielen statt Iridium eine Iridium-Rhenium-Legierung mit 0,1 Gew.-% Rhenium, 1 Gew.-% Rhenium und 8 Gew.-% Rhenium, so ist eine weitere Steigerung der Hochtemperaturfestigkeit bei gleichzeitiger Reduzierung der Neigung zur Lunkerbildung festzustellen, wobei mit 1 Gew.-% Rhenium die besten Ergebnisse erzielt wurden. Bei einer Dotierung über 8 Gew.-% Rhenium wird die Verarbeitbarkeit der Legierung schwierig.

### Ausführungsbeispiele:

Erfindungsgemäße Iridiumlegierungen sind durch Umschmelzen von Vorlegierungen mit Ir erhältlich.

Eine Ir Hf 1 und eine Ir Mo 1 Vorlegierung wird im Lichtbogen hergestellt.

Hierbei erfolgt ein Schmelzprozess in einer Lichtbogenanlage mit W- Elektrode nach
■ Einwiegen von 99 g Ir und 1 g Hf
■ Chargieren in eine wassergekühlte Cu-Kokille
■ Evakuieren
■ 300 mbar Argon fluten
■ Lichtbogen zünden und die Legierung aufschmelzen
■ Mehrmaligem Umschmelzen, um eine homogene Legierung zu erhalten.

Für Ir Mo 1 wird der Prozess entsprechend wiederholt.

Beim Herstellungsprozess der Legierungsschmelze wird gegebenenfalls Re zugegeben und die beiden Vorlegierungen in die Ir-Schmelze getaucht, um eine Oxidation der Legierungsbestandteile zu verhindern. Hierzu werden die Vorlegierungen mit einem Stab aus Zirkoniumoxid in die Iridiumschmelze geführt und gegen Auftauchen gehalten.

3 kg einer Legierung aus Ir - 1% Re - 0,04% Mo - 0,02% Hf wurden unter Argonatmosphäre induktiv erschmolzen und gemäß üblicher Praxis in eine Kupferkokille mit den Abmessungen 20 mm x 70 mm x 100 mm gegossen. Auffällig bei dem Barren war die geringere Lunkerbildung, als bei reinem Iridium üblicherweise beobachtet wird. Der Barren wurde gemäß normaler Praxis heiß geschmiedet und auf eine Dicke von 1 mm heiß gewalzt, wobei er vor jedem Walzstich auf 1400°C erwärmt wurde. Bei der Heißumformung verhielt sich die Legierung ähnlich gut wie reines Iridium. Analog dem reinen Iridium erfolgte nach der Umformung eine Schlussglühung von 20 Minuten / 1400°C. Eine metallographische Schliffuntersuchung zeigte ein gleichmäßig rekristallisiertes Gefüge mit einer mittleren Korngröße von 0,095 mm.

Aus diesem legierten Ir-Blech wurde eine Probe geschnitten und 100 Stunden bei 1400°C ausgelagert. Im metallographischen Schliff wurde ein gleichmäßig rekristallisiertes Gefüge mit mittlerer Korngröße 0,11 mm festgestellt.

Aus demselben legierten Ir-Blech wurden 3 Proben für Zeitstandversuche geschnitten. Diese Proben wurden bei 1800°C unter einer Belastung von 16,9 MPa - entsprechend der Belastung, die für reines Iridium eine Standzeit von 10,0 Stunden ergeben hatte - unter einer Atmosphäre aus Ar/H2 95/5 getestet. Die Zeit bis zum Bruch der einzelnen Proben betrug 15,4; 16,6 bzw. 18,8 Stunden.

Ein weiterer Barren mit der gleichen Legierungszusammensetzung wurde erschmolzen und zu einem 2,4 mm dicken Blech umgeformt. Aus diesem Blech wurde durch Heißtiefziehen ein zylindrischer Tiegel mit Außendurchmesser 50 mm und Höhe 60 mm hergestellt. Bei der Umformung verhielt sich die Legierung analog reinem Ir.

Unter Verwendung dieses Tiegels wurde nach dem Czochralski-Verfahren ein Einkristall aus Neodym-Yttrium-Aluminium-Granat gezüchtet.

Auf analoge Weise wurde ein Barren aus der Legierung Ir - 0,3% Mo - 0,04% Hf erschmolzen, gegossen und zu einem 1 mm-Blech umgeformt. Nach der Schlussglühung wies das Blech ein gleichmäßig rekristallisiertes Gefüge mit einer mittleren Korngröße von 0,3 mm auf.

Nach einer zusätzlichen Probeglühung von 100 Stunden bei 1400°C wurde ein gleichmäßig rekristallisiertes Gefüge mit einer mittleren Korngröße von 0,6 mm festgestellt.

Im Zeitstandversuch bei 1800°C unter einer Belastung von 16,9 MPa wurden an 3 Proben Standzeiten von 12,0; 12,6 bzw. 13,1 Stunden gemessen.

Auf analoge Weise wurde ein Barren aus der Legierung Ir - 3% Re - 0,05% Mo - 0,03% Hf erschmolzen, gegossen und zu einem 1mm-Blech umgeformt. Nach der Schlussglühung wies das Blech ein gleichmäßig rekristallisiertes Gefüge mit einer mittleren Korngröße von 0,075 mm auf.

Nach einer zusätzlichen Probeglühung von 100 Stunden bei 1400°C wurde ein gleichmäßig rekristallisiertes Gefüge mit einer mittleren Korngröße von 0,09 mm festgestellt.

Im Zeitstandversuch bei 1800°C unter einer Belastung von 16,9 MPa wurden an 3 Proben Standzeiten von 18,1; 19,7 bzw. 20,9 Stunden gemessen.

Ein weiterer Barren mit der gleichen Legierungszusammensetzung wurde erschmolzen und zu einem 2,4 mm dicken Blech umgeformt. Aus diesem Blech wurde durch Heiß-Tiefziehen ein zylindrischer Tiegel mit Außendurchmesser 30 mm und Höhe 35 mm hergestellt. Bei der Umformung war eine höhere Kraftanwendung als beim reinen Iridium erforderlich. Ebenfalls musste der Tiegel häufiger einer Zwischenglühung (10 Minuten / 1400°C) unterzogen werden als bei reinem Iridium üblich. Ansonsten verlief die Umformung einwandfrei.

Unter Verwendung dieses Tiegels wurde nach dem Czochralski-Verfahren ein Einkristall aus Saphir aus einer Aluminiumoxidschmelze gezüchtet.

### Vergleichsbeispiele:

Eine Probe aus einem 1 mm dicken Blech aus reinem Iridium wurde nach dem Walzen und der Schlussglühung 20 Minuten / 1400°C im metallographischen Schliff untersucht. Die Probe zeigte ein gleichmäßig rekristallisiertes Gefüge mit einer mittleren Korngröße von 0,7 mm.

Eine weitere Probe aus demselben Ir-Blech wurde nach der Schlussglühung weitere 100 Stunden bei 1400°C ausgelagert und metallographisch untersucht. Die Probe zeigte ein rekristallisiertes Gefüge mit teilweiser Grobkombildung. Die Korngröße war ungleichmäßig zwischen 1 und 2 mm.

10 Proben aus demselben Ir-Blech wurden nach der Schlussglühung unter verschiedenen Lasten zwischen 6 und 25 MPa bei 1800°C unter einer Atmosphäre aus Ar/H2 95/5 beansprucht und die Zeit bis zum Bruch der einzelnen Proben wurde ermittelt. Für eine Belastung von 16,9 MPa wurde eine Standzeit von 10,0 Stunden bis zum Bruch ermittelt.

## Patentansprüche

1. Iridium-Legierung aus mindestens 85 Gew.-% Iridium, mindestens 0,005 Gew-% Molybdän, 0,0005 bis 0,6 Gew.-% Hafnium und gegebenenfalls Rhenium, wobei die Summe aus Molybdän und Hafnium zwischen 0, 02 und 1,2 Gew.-% beträgt.

2. Iridium-Legierung nach Anspruch 1, **gekennzeichnet durch** 0 bis 8 Gew-% Rhenium, 0,01 bis 0,8 Gew.-% Molybdän und 0,002 bis 0,4 Gew.-% Hafnium.

3. Iridium-Legierung nach Anspruch 1 oder 2, **dadurch gekennzeichnet, dass** sie 0,1 bis 5 % Rhenium aufweist.

4. Iridium-Legierung nach einem der Ansprüche 1 bis 3, **dadurch gekennzeichnet, dass** sie 0,02 bis 0,3 Gew.-% Molybdän aufweist.

5. Iridium-Legierung nach einem der Ansprüche 1 bis 4, **dadurch gekennzeichnet, dass** sie 0,002 bis 0,2 Gew.-% Hafnium aufweist.

6. Verfahren zur Herstellung einer Iridiumlegierung nach einem der vorherigen Ansprüche, **dadurch gekennzeichnet, dass** je eine IrMo- und IrHf-Vorlegierung im Lichtbogen erzeugt werden und gegebenenfalls mit Re in eine Iridiumschmelze getaucht werden.

7. Tiegel, Wanne oder Glasbearbeitungswerkzeug aus einer Iridium-Legierung nach einem der Ansprüche 1 bis 6.

8. Verwendung eines Tiegels nach Anspruch 7 zur Züchtung von Kristallen aus hochschmelzenden oxidischen Schmelzen, insbesondere Aluminiumoxid oder Neodym-Yttrium-Aluminiumgranat.

9. Verwendung eines Tiegels, einer Wanne oder Glasbearbeitungswerkzeuges nach Anspruch 7 zur Herstellung von hochschmelzenden Gläsern.

## Claims

1. Iridium alloy comprising at least 85 % by weight of iridium, at least 0.005 % by weight of molybdenum, 0.0005 to 0.6 % by weight of hafnium and optionally rhenium, the sum of molybdenum and hafnium being between 0.02 and 1.2 % by weight.

2. Iridium alloy according to Claim 1, **characterized by** 0 to 8 % by weight of rhenium, 0.01 to 0.8 % by weight of molybdenum and 0.002 to 0.4 % by weight of hafnium.

3. Iridium alloy according to Claim 1 or 2, **characterized in that** it has 0.1 to 5 % of rhenium.

4. Iridium alloy according to any of Claims 1 to 3, **characterized in that** it has 0.02 to 0.3 % by weight of molybdenum.

5. Iridium alloy according to any of Claims 1 to 4, **characterized in that** it has 0.002 to 0.2 % by weight of hafnium.

6. Process for the production of an iridium alloy according to any of the preceding claims, **characterized in that** one IrMo master alloy and one IrHf master alloy are produced in an arc and are immersed in an iridium melt, optionally with Re.

7. Crucible, trough or glass processing tool comprising an iridium alloy according to any of Claims 1 to 6.

8. Use of a crucible according to Claim 7 for growing crystals from high-melting oxide melts, in particular alumina or neodymium yttrium aluminium garnet.

9. Use of a crucible, trough or glass processing tool according to Claim 7 for the production of high-melting glasses.

## Revendications

1. Alliage d'iridium constitué d'au moins 85 % en poids d'iridium, d'au moins 0,005 % en poids de molybdène, de 0,0005 à 0,6 % en poids d'hafnium et éventuellement de rhénium, la somme du molybdène et de l'hafnium étant comprise entre 0,02 et 1,2 % en poids.

2. Alliage d'iridium selon la revendication 1, **caractérisé par** de 0 à 8 % en poids de rhénium, de 0,01 à 0,8 % en poids de molybdène et de 0,002 à 0,4 % en poids d'hafnium.

3. Alliage d'iridium selon la revendication 1 ou 2, **caractérisé en ce qu'**il présente de 0,1 à 5 % de rhénium.

4. Alliage d'iridium selon l'une quelconque des revendications 1 à 3, **caractérisé en ce qu'**il présente de 0,02 à 0,3 % en poids de molybdène.

5. Alliage d'iridium selon l'une quelconque des revendications 1 à 4, **caractérisé en ce qu'**il présente de 0,002 à 0,2 % en poids d'hafnium.

6. Procédé pour la préparation d'un alliage d'iridium selon l'une quelconque des revendications précédentes, **caractérisé en ce que** l'on produit à chaque fois un préalliage d'IrMo et d'IrHf dans un arc électrique et **en ce que** l'on les immerge éventuellement avec Re dans une masse d'iridium en fusion.

7. Creuset, cuve ou outil pour le travail du verre constitué d'un alliage d'iridium selon l'une quelconque des revendications 1 à 6.

8. Utilisation d'un creuset selon la revendication 7 pour la culture de cristaux à partir de masses en fusion obtenues par voie oxydante de point de fusion élevé, en particulier d'oxyde d'aluminium on de grenat de néodyne-yttrium-aluminium.

9. Utilisation d'un creuset, d'une cuve ou d'un outil pour le travail du verre selon la revendication 7 pour la préparation de verres de point de fusion élevé.
